Europäisches Patentamt

European Patent Office

Office européen des brevets

(19)

(11) Veröffentlichungsnummer: **0 212 734 B1**

# EUROPÄISCHE PATENTSCHRIFT

(12)

(45) Veröffentlichungstag der Patentschrift: **23.05.90**

(51) Int. Cl.⁵: **G 01 N 24/08**

(21) Anmeldenummer: **86201356.2**

(22) Anmeldetag: **01.08.86**

(54) **Verfahren zur Bestimmung eines Kernspinresonanzspektrums.**

(30) Priorität: **08.08.85 NL 8502205**

(43) Veröffentlichungstag der Anmeldung:
**04.03.87 Patentblatt 87/10**

(45) Bekanntmachung des Hinweises auf die
Patenterteilung:
**23.05.90 Patentblatt 90/21**

(84) Benannte Vertragsstaaten:
**BE DE FR GB IT SE**

(56) Entgegenhaltungen:
**EP-A-0 088 970
DE-A-2 936 465
US-A-4 318 043
JOURNAL OF MAGNETIC RESONANCE, Band 9,
1973, Seiten 358-362, Academic Press Inc., New
York, US; G.G. McDONALD et al.: "A new
method for measuring longitudinal relaxation
times"**

**IEEE TRANSACTIONS ON MEDICAL IMAGING,
Band MI-1, Nr. 1, Juli 1982, Seiten 42-47, IEEE,
New York, US; A. MACOVSKI: "Selective
projection imaging: Applications to radiography
and NMR"**

(73) Patentinhaber: **N.V. Philips'
Gloeilampenfabrieken
Groenewoudseweg 1
NL-5621 BA Eindhoven (NL)**

(72) Erfinder: **Den Hollander, Jan Anthonie
INT. OCTROOIBUREAU B.V. Prof. Holstlaan 6
NL-5656 AA Eindhoven (NL)**
Erfinder: **Luyten, Peter Rudolf
INT. OCTROOIBUREAU B.V. Prof. Holstlaan 6
NL-5656 AA Eindhoven (NL)**

(74) Vertreter: **Faessen, Louis Marie Hubertus et al
INTERNATIONAAL OCTROOIBUREAU B.V. 6
Prof. Holstlaan
NL-5656 AA Eindhoven (NL)**

(56) References cited:
**JOURNAL OF MAGNETIC RESONANCE, Band
56, 1984, Seiten 350-354, Academic Press Inc.,
New York, US; W.P. AUE et al.: "Volumeselective excitation. A novel approach to topical
NMR"**

Courier Press, Leamington Spa, England.

**Beschreibung**

Die Erfindung betrifft ein Verfarhen zur Bestimmung eines Frequenzspektrums von Kernspinresonanzsignalen in einem ausgewählten Volumen eines Körpers, das sich in einem statischen einheitlichen Magnetfeld befindet und mit elektromagnetischen Hochfrequenzimpulsen bei einem Gradientenmagnetfeld zum Erhalten eines Kernspinresonanzsignals (Kerninduktionssignal) angeregt wird, aus dem das Frequenzspektrum im genannten Volumen vorhandener Kernspins abgeleitet wird.

Ein derartiges Verfahren ist bekannt und beispielsweise in "Journal of Magnetic Resonance" 56, 350—354 (1984) von W. P. Aue u.a. beschrieben. Beim beschriebenen Verfahren werden in Reihenfolge nacheinander ein Gradientenmagnetfeld in x-Richtung, in y-Richtung und in z-Richtung angelegt, wobei jeweils be einem derartigen Gradientenmagnetfeld ein zusammengesetzter Hochfrequenzimpuls erzeugt wird. Die zusammengesetzten Hochfrequenzimpulse enthalten aufeinanderfolgend je einen selektiven 45°-Impuls, eine 90°-Breitbandimpuls und einen selektiven 45°-Impuls. Nach diesen drei zusammengesetzten Impulsen hat ein Teilvolumen, das durch die Gradientenstärke de angelegten Gradientenfelder, die Stärke des statischen einheitlichen Magnetfeldes un durch die Frequenz der selektiven Impulse bestimmt ist, eine negative Magnetisierung in z-Richtung. Nach einem weiteren 90°-Impuls (breitbandig, also nicht selektiv) kann aus dem dann zu messenden Kerninduktionssignal ein genaues Spektrum des Stoffes im ausgewählten Volumen bestimmt werden.

Die zwei selektiven 45°-Impulse sind als ein einziger selektiver 90°-Impuls zu betrachten, während dessen ein nicht-selektiver 90°-Impuls erzeugt wird. Da wegen der erforderlichen Selektivität ein Gradientenmagnetfeld angelegt ist, während auch ein nicht-selektiver 90°-Impuls erzeugt werden muss, soll zur Vermeidung jeglicher Selektivität dieser nicht-selektive 90°-Impuls sehr breitbandig und deshalb sehr kurz sein. Obiges erfordert eine sehr hohe Spitzenleistung des Hf-Senders, der diesen nicht-selektiven 90°-Impuls erzeugen muss, was einen Nachteil bedeutet.

Das bekannte Verfahren hat den Nachteil, dass es auf der Summierung von Rotationen von Magnetisierungen durch die verschiedenen Anregungsimpulse basiert. Diese Impulse müssen im ganzen Objekt bzw. im ausgewählten Volumen in diesem Objekt eine Gesamtrotation von Spins über einen Winkel von 270° bzw. 540° bewirken, was nicht ganz der Fall ist. Die Kernspins in der ausgewählten x-Scheibe (Gradientenfeld Gx und zwei selektive 45°-Impulse) erfahren nämlich während der drei zusammengesetzten Impulse eine Drehung von 360° (mit Ausnahme des ausgewählten Volumens und der zwei Orthogonalschnitte (Rotation 450°) der x-Scheibe durch die ausgewählten y- und z-Scheiben). Gleiches gilt für die Rotation der Kernspins in den ausgewählten y- und z-Scheiben (Auswahl mit zwei 45°-Impulsen bei Gy bzw. Gz). Ein nach den drei zusammengesetzten Impulsen zu erzeugender 90°-Impuls ruft also ein Resonanzsignal nicht nur des ausgewählten Volumens auf, sondern auch der (viel grösseren) Volumen der ausgewählten x-, y- und z-Scheiben. Selbstverständlich tritt in den genannten (viel grösseren) Volumen Phasenstreuung auf, aber die von den Kernspins in diesen Volumen erzeugten Signale sind unerwünscht und als Störsignale zu betrachten.

Der Erfindung liegt die Aufgabe zugrunde, ein Verfahren anzugeben, mit dem aus einem ausgewählten Volumen ein Frequenzspektrum insbesondere für Stoffe bestimmbar ist, die eine verhältnismässige kurze Querrelaxationskonstante T2 (transversale Relaxationszeit T2) haben.

Zur Lösung dieser Aufgabe ist das erfindungsgemässe Verfahren dadurch gekennzeichnet, dass das das Frequenzspektrum bestimmende Signal aus Unterschieden zumindest zweier getrennter Resonanzsignale oder ihrer Fourier-Transformatierten abgeleitet wird, wobei ein Resonanzsignal nach Anregung mit lediglich einem 90°-Hf-Impuls und ein anderes Resonanzsignal nach Vorbereitung mit einem selektiven 180°-Hf-Impuls bei einem Gradientenmagnetfeld nach dem Abschalten des Gradientenmagnetfelds mit dem Erzeugen eines 90°-Hf-Impuls gemessen wird. Beim erfindungsgemässen Verfahren wird erreicht, dass der ganze Körper eine Magnetisierung hat, die der Magnetisierung des ausgewählten Volumens entgegengesetzt ist. Nach einer folgenden 90°-Hf-Anregung wird ein Kerninduktionssignal empfangen, das Signale des ganzen Objekts enthält, wobei die Signalbeiträge aus dem ausgewählten Volumen negative sind. Wird anschliessend ein Kerninduktionssignal gemessen, das nur mit einem 90°-Hf-Impuls erzeugt wird und das also Signale aus dem ganzen Objekt empfängt, kann aus dem Unterschied der beiden Kerninduktionssignale das Frequenzspektrum des augewählten Volumens bestimmt werden. Der Unterschied zwischen beiden Signalen kann Fourier-transformiert oder es kann Unterschied zwischen den Fourier-Transformierten jedes Signals bestimmt werden.

Ein weiteres Ausführungsbeispiel eines erfindungsgemäss Verfahrens ist dadurch gekennzeichnet, dass das Signal aus vier Resonanzsignalen abgeleitet wird, wobei ein erstes Resonanzsignal nach Anregung mit einem nicht-selektiven 90°-Hf-Impuls ohne jegliche Vorbereitung, ein zweites Resonanzsignal nach einer Vorbereitung mit einem Gradientenmagnetfeld mit einem Gradienten ein einer ersten Richtung und mit einem selektiven 180°-Hf-Impuls nach einem nachfolgenden nicht-selektiven 90°-Hf-Impuls, ein drittes Resonanzsignal nach einer Vorbereitung mit einem Gradientenmagnetfeld mit einem Gradienten in einem orthogonal zur ersten Richtung verlaufenden zweiten Richtung und mit einem selektiven 180°-Hf-Impuls nach einem nicht-selektiven 90°-Hf-Impuls und ein viertes Resonanzsignal nach einer Vorbereitung mit aufeinanderfolgend dem ersten und dem zweiten Gradientenmagnetfeld, bei dem bei jedem Feld ein selektiver 180°-Hf-Impuls erzeugt wird, nach einem nicht-selektiven 90°-Hf-Impuls gemessen werden, und die ersten und vierten Resonanzsignale einen positiven Beitrag zum Signal liefern,

2

während die zweiten und dritten Resonanzsignale einen negativen Beitrag liefern. Mit diesem Verfahren wird von einem stabförmigen Volumen in einem Objekt ein Frequenzspektrum bestimmt, bei dem durch geeignete Wahl der zwei Gradientenfelder und des Frequenzumfangs des selektiven 180°-Hf-Impulses der "Stab" beliebig im Objekt befindlich sein kann.

Ein bevorzugtes Ausführungsbeispiel eines erfindungsgemässen Verfahrens ist dadurch gekennzeichnet, dass das Signal aus acht Resonanzsignalen abgeleitet wird, von denen ein Resonanzsignal nach einem nicht-selektiven 90°-Hf-Impuls und die anderen sieben Resonanzsignale nach einem nicht-selektiven 90°-Hf-Impuls gemessen werden, der nach einer Vorbereitung folgt, bei der drei Gradientenmagnetfelder mit quer zueinander gerichteten Gradienten benutzt werden und zum Vorbereiten der sieben Resonanzsignale in den sieben verschiedenen Vorbereitungen das erste, das zweite, das dritte, das erste und zweite einander auffolgend und das erste, zweite und dritte einander auffolgende Gradientenmagnetfeld jeweils eingeschaltet wird bzw. werden, wobei bei jedem Gradientenmagnetfeld eine selektiver 180°-Hf-Impuls erzeugt wird, bei dem die Resonanzsignale ohne Vorbereitung oder mit einer Vorbereitung, in der zwei 180°-Hf-Impulse erzeugt werden, einen positiven Beitrag zum Signal und die Resonanzsignale mit einer Vorbereitung, in der eine ungerade Anzahl von 180°-Hf-Impulsen erzeugt werden, einen negativen Beitrag liefern. Mit diesem Verfahren ist ein Frequenzspektrum eines würfelartigen Volumens an einer beliebigen Stelle in einem Objekt bestimmbar, was bei diesem Verfahren auch für Objekte möglich ist, die Stoff mit einer geringen Querrelaxationszeit T2 (transversaler Relaxationszeit) besitzen.

Ausführungsbeispiele der Erfindung werden nachstehend anhand der Zeichnung näher erläutert. Es zeigen

Fig. 1a und b ein erfindungsgemässes Verfahren,
Fig. 2a, b, c und d ein weiteres erfindungsgemässes Verfahren, und
Fig. 3 ein bevorzugtes Ausführungsbeispiel eines erfindungsgemässen Verfahrens.

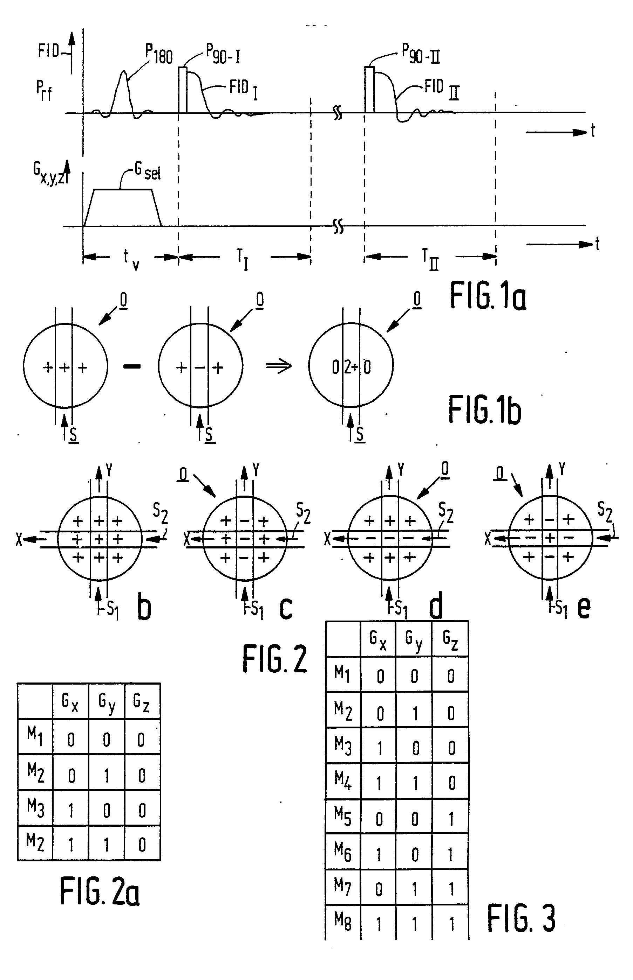

In Fig. 1a und 1b ist schematisch ein Verfahren nach der Erfindung dargestellt. In Fig. 1a ist ein Messzyklus dargestellt, der mit einer Anordnung nach der Beschreibung in der niederländischen Patentanmeldung 82-03519 durchführbar ist, wenn sie mit einem geeigneten Steuerprogramm ausgerüstet wird. Der Messzyklus ist in 3 Zeitabschnitte verteilt $t_v$, $T_I$ und $T_{II}$. In einem vorbereitenden Zeitabschnitt $t_v$ wird ein Gradientenmagnetfeld $G_{sel}$ eingeschaltet und ein selektiver 180°-Hf-Impuls erzeugt. Das Gradientenmagnetfeld $G_{sel}$ ist in diesem Fall eines der Gradientenmagnetfelder $G_x$, $G_y$ oder $G_z$, die einen Feldstärkegradienten in der x-, y- bzw. z-Richtung aufweisen. Nach Ablauf des vorbereitenden Zeitabschnitts $t_v$ (möglichst kurz) fängt ein erster Messzeitabschnitt $T_I$ mit einem nicht-selektiven 90°-Anregungsimpuls $P_I$ an. Das mit dem Impuls $P_I$ erzeugte Resonanzsignal $FID_I$ (Kerninduktionssignal) wird abgetastet. Es folgt darauf eine Wartezeit, die länger als die longitudinale Relaxationszeit ($T_I$) des zu untersuchenden Stoffes ist, um die mit dem 180°-Impuls invertierten Kernspins nach ihrem Wärmegleichwicht (in einem angelegten statischen einheitlichen Magnetfeld Bo) zurückkehren zu lassen. Der letzte Zeitabschnitt $T_{II}$ des Messzyklus fängt mit einem nicht-selektiven Anregungsimpuls $P_{90-II}$ an, mit dem ein zweites Resonanzsignal $FID_{II}$ erzeugt wird. Das Signal $FID_{II}$ wird in dem zweiten Messzeitabschnitt $T_{II}$ abgetastet.

Mit dem vorangehenden Messzyklus ist folgendes erreicht. Das Signal $FID_{II}$ enthält Signale aus dem ganzen mit dem 90°-Hf-Impuls $P_{II}$ angeregten Objekt O, was in Fig. 1b mit der ganz linken Abbildung angegeben ist. Im ersten Messzyklus $T_I$ werden Kernspins mit dem selektiven 180-Hf-Impuls $P_{180}$ in einem Volumen S (eine Schicht oder auch eine Scheibe) des Objekts O invertiert. Nach der Anregung des ganzen Objekts O durch den nicht selektiven 90°-Hf-Impuls $P_{90-I}$ werden auch aus dem ganzen Objekt O Signale empfangen, aber die Signale der invertierten Kernspins in der ausgewählten Schicht S haben ein Signal mit entgegengesetztem Vorzeichen. In der mittleren Abbildung ist die ausgewählte Schicht S angegeben und mit einem Minuszeichen versehen, während der ausserhalb der ausgewählten Schicht S befindliche Stoff mit einem Pluszeichen versehen ist. Es ist jetzt ersichtlich, dass durch die Subtraktion des Signals $FID_I$ vom Signal $FID_{II}$ nur ein Signal übrigbleibt, das nur vom ausgewählten Volumen S erzeugt ist (und in der Amplitude zweimal grösser ist als im Fall, dass Kernspins aus diesem Volumen allein ein Signal erzeugen würden, was für den Signal/Rausch-Abstand vorteilhalft ist). Aus dem Differenzsignal zwischen den zwei Resonanzsignalen $FID_{II}$ und $FID_I$ ist mittels Fourier-Transformation ein Frequenzspektrum des im ausgewählten Volumen S vorhandenen Stoffes bestimmbar. Selbstverständlich kann das genannte Frequenzspektrum auch aus dem Unterschied zwischen den Fourier-Transformierten der Signale $FID_I$ und $FID_{II}$ bestimmt werden.

In Fig. 2a, b, c, d und e ist schematisch ein weiteres Ausführungsbeispiel eines erfindungsgemässen Verfahrens dargestellt. Mit dem anhand der Fig. 1a und 1b beschriebenen Verfahren ist es möglich, Resonanzsignale aus einer Schicht an einer beliebigen Stelle in einem dreidimensionalen Körper zu messen. Mit dem in Fig. 2a bis e beschriebenen Verfahren ist es möglich, von einem länglichen (stabförmigen) Volumen mit geringen Querschnitt, das sich an einer beliebigen Stelle in einem dreidimesionalen Objekt befindet, Resonanzsignale zu messen. Der Messzyklus enthält jetzt vier Zeitabschnitte M1, M2, M3, M4 und wird anhand der Fig. 2a beschrieben. Der Zeitabschnitt M1 entspricht dem Messzeitabschnitt $T_{II}$ nach Fig. 1a. Im Zeitabschnitt M1 sind keine Gradientenmagnetfelder Gx, Gy oder Gz eingeschaltet, was in der Tabelle der Fig. 2a mit (O, O, O) angegeben ist. Der zweite Zeitabschnitt M2 entspricht der Kombination des vorbereitenden Zeitabschnitts $t_v$ und des Messzeitabschnitts $T_I$, bei der im vorbereitenden Zeitabschnitt $T_v$ das Gradientenmagnetfeld Gy und ein zugeordneter selektiver 180°-Hf-Impuls erzeugt wird. In der Tabelle nach Fig. 2a ist dies mit (0, 1, 0) angegeben. Der dritte Zeitabschnitt M3 ist nahezu gleich dem zweiten Zeitabschnitt M2, wobei statt des Gradientenmagnetfeldes Gy das Gradientenmagnetfeld Gx eingeschaltet wird. In der Tabelle ist dies mit (1, 0, 0) angegeben. Der vierte Zeitabschnitt M4 weicht insoweit von den Zeitabschnitten M3 und M2 ab, dass in dem vorbereitenden Zeitabschnitt $t_v$ zunächst das eine Gradientenmagnetfeld (z.B. Gx) einige Zeit und anschliessend das andere Gradientenmagnetfeld (Gy) einige Zeit eingeschaltet wird, wobei sowohl beim einen (Gx) als auch beim anderen Gradientenmagnetfeld (Gy) ein selektiver 180°-Hf-Impuls erzeugt wird.

Im ersten Zeitabschnitt M1 wird ein Resonanzsignal f1 (Kerninduktionssignal) gemessen, das Kernspins aus dem ganzen Objekt O erzeugen. In Fig. 2b ist dies (analog der Fig. 1b) wiedergegeben. Es ist ersichtlich, dass durch die Verwendung des Gradientenmagnetfeldes Gy bzw. Gx und eines selektiven 180°-Hf-Impulses beim Zeitabschnitt M2 bzw. M3 die Kernspins in einer ausgewählten y-Schicht bzw- x-Schicht invertiert sind und daher einen negativen Beitrag zum zu messenden Resonanzsignal f2 bzw. f3 liefern. Obiges ist schematisch in Fig. 2c und 2d dargestellt, wobei in Fig. 2c eine y-Schicht $S_1$ und in Fig. 2d eine x-Schicht $S_2$ mit einem Minuszeichen und die herumliegenden Teile des Objektes O mit einem Pluszeichen versehen sind. In Fig. 2e ist das Ergebnis einer Messung im Zeitabschnitt M4 dargestellt. Mit einem ersten selektiven 180°-Impuls bei einem Gradientenmagnetfeld (z.B. Gy) werden die Kernspins in einer ersten Schicht (z.B. $S_1$) invertiert, wonach der zweite selektive 180°-Impuls (beim Gradientenmagnetfeld $G_x$) die Kernspins in einer kleinen x-Schicht ($S_2$) invertiert. Das Ergebnis davon ist, dass im Schnitt der y- und der x-Schicht $S_1$ und $S_2$ die Kernspins eine Drehung von 360° gemacht haben und wieder aufrechtstehen. Die Kernspins im Schnitt von $S_1$ und $S_2$ liefern also jetzt einen positioven Beitrag und die Kernspins in den übrigen Teilen der genannten Schichten $S_1$ und $S_2$ liefern einen negativen Beitrag zu einem im vierten Zeitabschnitt M4 zu messenden Resonanzsignal f4.

Es ist jetzt ersichtlich, dass aus den vier Resonanzsignalen f1, f2, f3 und f4 ein Differenzsignal ableitbar ist, das dem Signal $\Delta f$ proportional ist, das erhalten werden würde, wenn nur der Schnitt der Schichten $S_1$ und $S_2$ angeregt würde: $\Delta f = (f1-f2) - (f3-f4)$. Das Signal $\Delta f$ ist selbst viermal grösser als das Resonanzsignal, das bei Anregung des Schnittes allein erzeugt würde, was für den Signal/Rauschabstand vorteilhaft ist.

Selbstverständlich ist auch hier von jedem Resonanzsignal f1, f2, f3, f4 die Fourier-Transformierte F1, F2, F3, F4 bestimmbar, so dass das Spektrum F des ausgewählten Volumens (der Schnitt der Schichten $S_1$ und $S_2$) daraus bestimmbar ist: $\Delta f = (F1-F2) - (F3-F4)$ statt der Bestimmung der Fourier-Transformierten des Differenzsignals $\Delta f$.

Aus obigen ist ableitbar, dass auf gleichartige Weise von einem begrenzten dreidimensionalen Volumen (kleiner Würfel: Grössenordnung mm³ bis cm³) in einem grossen Objekt ein Frequenzspektrum bestimmbar ist, das nicht durch Stoff ausserhalb des ausgewählten Volumens beeinflusst wird. In Fig. 3 ist eine Tabelle dargestellt, in der angegeben ist, in welchem Zeitabschnitt M1, M2, .... M8 welches Gradientenmagnetfeld oder welche Gradientenmagnetfelder Gx, Gy und/oder Gz eingeschaltet werden. Dazu lässt sich bemerken, dass die Zeitabschnitte M1, M2, M3 und M4 den Zeitabschnitten M1, M2, M3 und M4 entsprechen, wie sie beim erfindungsgemässen Verfahren anhand der Fig. 2a beschrieben wurden. Es ist ersichtlich, dass im Zeitabschnitt M5, (Fig. 3, M5: 0, 0, 1) das Gradientenmagnetfeld Gz in der Vorbereitungszeit $t_v$ eingeschaltet wird (siehe Fig. 1a), wobei ein selektiver 180°-Hf-Impuls erzeugt wird, wonach nach einem nicht-selektiven 90°-Hf-Impuls das Resonanzsignal f5 (Kerninduktionssignal) gemessen wird. In den Zeitabschnitten M6 und M7 werden die Gradientenmagnetfelder Gx und Gz bzw. Gy und Gz nacheinander in der Vorbereitungszeit $t_v$ eingeschaltet (jeweils mit dem zugeordneten selektiven 180°-Hf-Impuls). Im Zeitabschnitt M8 (Fig. 3; M8: 1, 1, 1) werden die Gradientenfelder Gx, Gy und Gz in der Vorbereitungszeit $t_v$ nacheinander eingeschaltet (mit zugeordneten 180°-Hf-Impulsen). Es ist nachweisbar, dass aus den gemessenen Resonanzsignalen f1, f2, ... f8 aus den acht Zeitabschnitten M1, M2, M3, ... M8 ein Differenzsignal $\Delta f$ berechenbar ist: $\Delta f = f1-f2-f3 + f4-f5 + f6 + f7-f8$, das nur von de Kernspinsignalen abhängig ist, die aus dem dreidimensionalen Volumen erzeugt werden, das von Schnitt der drei mit den 180°-Impulsen und den Magnetfeldgradienten Gx, Gy und Gz ausgewählten x-, y- und z-Schicht in einem zu untersuchenden Objekt bestimmt ist. Nach der Fourier-Transformation des Differenzsignals $\Delta f$ ist das Frequenzspektrum $\Delta F$ des indirekt ausgewählten Volumens verfügbar. Selbstverständlich kann das Frequenzspektrum $\Delta F$ auch durch das Zusammennehmen der Fourier-Transformationen der acht Signal f1, f2, ... f8 bestimmt werden: $F = F1-F2-F3 + F4-F5 + F6 + F7-F8$ wobei F1, F2, ... F8 die Fourier-Transformation des Signals f1, f2, ... f8 ist. Es sei bemerkt, dass das Differenzsignal f achtmal stärker als das Signal ist, das gemessen würde, wenn nur das gewünschte Volumen angeregt wird.

Es sei bemerkt, dass Abwandlungen des vorangehend beschriebenen Verfahrens möglich sind, ohne aus dem Rahmen der Erfindung herauszutreten. So ist es möglich, nach einem Zeitabschnitt M1 (siehe Fig. 2a oder Fig. 3) in einem darauffolgenden Zeitabschnitt $t_v$ gleichzeitig zwei Gradientenfelder (z.B. Gx und Gy) einzuschalten und dabei einen selektiven 180°-Hf-Impuls zu erzeugen. Die Kernspins in einem Volumen, das durch Flächen parallel zur z-Achse begrenzt wird, die durch $(x_o, 0)$, $(y_o, 0)$ und $(-x_o, 0)$, $(0, -y_o)$ gehen, werden invertiert. Durch die Subtraktion des danach zu erzeugenden Resonanzsignals vom Signal f1 aus dem Zeitabschnitt M1 wird das Differenzsignal für das oben angegebene Volumen gefunden. Jedoch weicht dieses Volumen vom Volumen ab, das mit dem Verfahren nach Fig. 2 und 2a bemessen wurde (vergleiche: das Volumen zwischen den Flächen parallel zur z-Achse, die durch die Koordinaten $(x_o, y_o)$, $(-x_o, y_o)$ und $(x_o, -y_o)$ $(-x_o, -y_o)$ gehen und das von den oben angegebenen Koordinaten bestimmte Volumen).

# EP 0 212 734 B1

## Patentansprüche

1. Verfahren zur Bestimmung eines Frequenzspektrums von Kernspinresonanzsignalen in einem ausgewählten Volumen eines Körpers, das sich in einem statischen einheitlichen Magnetfeld befindet und mit elektromagnetischen Hochfrequenzimpulsen bei einem Gradientenmagnetfeld zum Erhalten eines Kernspinsresonanzsignals angeregt wird, aus dem das Frequenzspektrum im genannten Volumen vorhandener Kernspins abgeleitet wird, dadurch gekennzeichnet, dass das Signal, das das Frequenzspektrum bestimmt, aus Unterschieden von zumindest zwei getrennten Resonanzsignalen oder von ihren Fourier-Transformierten abgeleitet wird, wobei ein Resonanzsignal nach Anregung mit lediglich einem 90°-Hf-Impuls und ein anderes Resonanzsignal nach Vorbereitung mit einem selektiven 180°-Hf-Impuls bei einem Gradientenmagnetfeld und nach Abschaltung des Gradientenmagnetfelds mit dem Erzeugen eines 90°-Hf-Impulses gemessen werden.

2. Verfahren nach Anspruch 1, dadurch gekennzeichnet, dass das Signal aus vier Resonanzsignalen abgeleitet wird, wobei ein erstes Resonanzsignal nach Anregung mit einem nicht-selektiven 90°-Hf-Impuls ohne jegliche Vorbereitung, ein zweites Resonanzsignal nach einer Vorbereitung mit einem Gradientenmagnetfeld mit einem Gradienten in einer ersten Richtung und mit einem selektiven 180°-Hf-Impuls nach einem darauffolgenden nicht-selektiven 90°-Hf-Impuls, ein drittes Resonanzsignal nach einer Vorbereitung mit einem Gradientenmagnetfeld mit einem Gradienten in einer orthogonal zur ersten Richtung verlaufenden zweiten Richtung und mit einem selektiven 180°-Hf-Impuls nach einem nicht-selektiven 90°-Hf-Impuls und ein viertes Resonanzsignal nach einer Vorbereitung mit aufeinanderfolgend dem ersten und dem zweiten Gradientenmagnetfeld, bei dem bei jedem Feld ein selektiver 180°-Hf-Impuls erzeugt wird, nach einem nicht-selektiven 90°-Hf-Impuls gemessen werden, und das erste und das vierte Resonanzsignal einen positiven Beitrag zum Signal liefern, während das zweite und das dritte Resonanzsignal einen negativen Beitrag liefern.

3. Verfahren nach Anspruch 1 oder 2, dadurch gekennzeichnet, dass das Signal aus acht Resonanzsignalen abgeleitet wird, von denen ein Resonanzsignal nach einem nichtselektiven 90°-Hf-Impuls und die anderen sieben Resonanzsignale nach einem nicht-selektiven 90°-Hf-Impuls gemessen werden, der einer Vorbereitung folgt, bei der drei Gradientenmagnetfelder mit quer zueinander gerichteten Gradienten benutzt werden, und zum Vorbereiten der sieben Resonanzsignale in den sieben verschiedenen Vorbereitungen das erste, das zweite, das dritte, das erste und zweite aufeinanderfolgend, das erste und das dritte aufeindanderfolgend, das zweite und das dritte aufeinanderfolgend bzw. das erste, zweite und dritte aufeinanderfolgende Gradientenmagnetfeld eingeschaltet wird bzw. werden, wobei bei jedem Gradientenmagnetfeld ein selektiver 180°-Hf-Impuls erzeugt wird, wobei die Reasonanzsignale ohne Vorbereitung oder mit einer Vorbereitung, in der zwei 180°-Hf-Impulse erzeugt werden, einen positiven Beitrag zum Signal liefern, und die Resonanzsignale mit einer Vorbereitung, in der eine ungerade Anzhal von 180°-Hf-Impulsen erzeugt wird, einen negativen Beitrag liefern.

4. Verfahren nach Anspruch 1, dadurch gekennzeichnet, dass das Gradientenmagnetfeld aus zumindest zwei Gradientenmagnetfeldern zusammengesetzt ist, deren Gradientenrichtungen quer zueinander verlaufen.

## Revendications

1. Procédé pour déterminer un spectre de fréquence de signaux de résonance magnétique nucléaire dans une volume choisi d'un corps qui se trouve dans un champ magnétique statique uniforme et qui est excité par des impulsions électromagnétiques haute fréquence dans un champ magnétique de gradient pour obtenir un signal de résonance magnétique nucléaire, à partir duquel le spectre de fréquence des spins nucléaires présents dans le volume cité est déduit, caractérisé en ce que le signal qui détermine le spectre de fréquence est déduit de différences d'au moins deux signaux de résonance distincts ou de leur transformée de Fourier, un signal de résonance étant mesuré après excitation à l'aide d'une seule impulsion Hf à 90° et un autre signal de résonance étant mesuré par la génération d'une impulsion Hf à 90° après une préparation à l'aide d'une impulsion Hf sélective à 180° en présence d'un champ magnétique de gradient et après coupure du champ magnétique de gradient.

2. Procédé suivant la revendication 1, caractérisé en ce que le signal est déduit de quatre signaux de résonance, un premier signal de résonance étant mesuré après excitation à l'aide d'une impulsion Hf à 90° non sélective sans aucune préparation, un second signal de résonance étant mesuré après une préparation à l'aide d'un champ magnétique de gradient avec un gradient dans une première direction et à l'aide d'une impulsion Hf à 180° sélective après une impulsion Hf à 90° non sélective suivante, un troisième signal de résonance étant mesuré après un préparation à l'aide d'un champ magnétique de gradient avec un gradient dans une deuxième direction orthogonale par rapport à la première direction et à l'aide d'une impulsion Hf à 180° sélective après une impulsion Hf à 90° non sélective, et un quatrième signal de résonance étant mesuré après une préparation à l'aide, successivement, du premier et du deuxième champ magnétique de gradient, pour lequel pendant chaque champ, une impulsion Hf à 180° selective est engendrée, après une impulsion Hf à 90° non sélective, et le premier et le quatrième signal de résonance apportent une contribution positive au signal, tandis que le deuxième et le troisième signal de résonance apportent une contribution négative.

3. Procédé suivant la revendication 1 ou 2, caractérisé en ce que le signal est déduit de huit signaux de résonance, parmi lesquels un signal de résonance est mesuré après une impulsion Hf à 90° non sélective et les sept autres signaux de résonance sont mesurés après une impulsion Hf à 90° non sélective qui succède à une préparation pendant laquelle trois champs magnétiques de gradient présentant des gradients dirigés perpendiculairement les uns aux autres sont utilisés, étant entendu que pour la préparation des sept signaux de résonance dans les sept différentes préparations, parmi les champs magnétiques de gradient, le premier, le deuxième, le troisième, le premier et le deuxième en succession, le premier et le troisième en succession, le deuxième et le troisième en succession ou le premier, le deuxième et le troisième en succession est ou sont chaque fois enclenchés, tandis que lors de chaque champ magnétique de gradient, une impulsion Hf à 180° sélective est engendrée, pendant laquelle les signaux de résonance sans préparation ou avec une préparation au cours de laquelle deux impulsions Hf à 180° sont engendrées apportent une contribution positive au signal et les signaux de résonance avec une préparation au cours de laquelle un nombre impair d'impulsions Hf à 180° sont engendrées apportent une contribution négative.

4. Procédé suivant la revendication 1, caractérisé en ce que le champ magnétique de gradient est composé d'au moins deux champs magnétiques de gradient dont les directions de gradient sont mutuellement perpendiculaires.

**Claims**

1. A method of determining a frequency spectrum of spin resonance signals in a selected volume of a body, which volume is situated in a static, uniform magnetic field and is excited by means of electromagnetic r.f. pulses in the presence of a gradient magnetic field in order to obtain a spin resonance signal wherefrom the frequence spectrum of spins present in said volume is derived, characterized in that the signal which determines the frequency spectrum is derived from differences between at least two separate resonance signals or between the Fourier transforms thereof, one resonance signal being measured after excitation by means of a 90° r.f. pulse, another resonance signal being measured after preparation with a selective 180° r.f. pulse in the presence of a gradient magnetic field, after de-activation of the gradient magnetic field, and after the generating of a 90° r.f. pulse.

2. A method as claimed in Claim 1, characterized in that the signal is derived from four resonance signals, a first resonance signal being measured after excitation by means of a non-selective 90° r.f. pulse without any preparation, after preparation by means of a gradient magnetic field having a gradient in a first direction and a selective 180° r.f. pulse there being measured a second resonance signal after a subsequent non-selective 90° r.f. pulse, after preparation by means of a gradient magnetic field having a gradient in a second direction which is orthogonal to the first direction and a selective 180° r.f. pulse there being measured in a third resonance signal after a subsequent non-selective 90° r.f. pulse, a fourth resonance signal being measured, after preparation by means of successively the first and the second gradient magnetic field during which each time a selective 180° r.f. pulse is generated, after a subsequent non-selective 90° r.f. pulse, the first and the fourth resonance signal making a positive contribution to the signal, whilst the second and the third resonance signal make a negative contribution.

3. A method as claimed in Claim 1 or 2, characterized in that the signal is derived from eight resonance signals, one resonance signal being measured after a non-selective 90° r.f. pulse whilst the seven other resonance signals are measured after a non-selective 90° r.f. pulse after preparation by means of three gradient magnetic fields having gradients which are directed transversely of one another, for the preparation of the seven resonance signals during the seven different preparation periods there being activated the first, the second, the third gradient magnetic field, the first and the second gradient magnetic field in succession, the first and the third gradient magnetic field in succession, the second and the third gradient magnetic field in succession, and the first, the second and the third gradient magnetic field in succession, respectively, in the presence of each gradient magnetic field there being generated a selective 180° r.f. pulse, the resonance signals without preparation, or with a preparation during which two 180° r.f. pulses are generated, making a positive contribution to the signal, whilst the resonance signals with a preparation during which an odd number of 180° r.f. pulses is generated make a negative contribution.

4. A method as claimed in Claim 1, characterized in that the gradient magnetic field is composed of at least two gradient magnetic fields whose gradient directions extend transversely of one another.

FIG.1a

FIG.1b

FIG.2

**FIG.2a**

|  | $G_x$ | $G_y$ | $G_z$ |
|---|---|---|---|
| $M_1$ | 0 | 0 | 0 |
| $M_2$ | 0 | 1 | 0 |
| $M_3$ | 1 | 0 | 0 |
| $M_2$ | 1 | 1 | 0 |

FIG. 3

|  | $G_x$ | $G_y$ | $G_z$ |
|---|---|---|---|
| $M_1$ | 0 | 0 | 0 |
| $M_2$ | 0 | 1 | 0 |
| $M_3$ | 1 | 0 | 0 |
| $M_4$ | 1 | 1 | 0 |
| $M_5$ | 0 | 0 | 1 |
| $M_6$ | 1 | 0 | 1 |
| $M_7$ | 0 | 1 | 1 |
| $M_8$ | 1 | 1 | 1 |